# EUROPÄISCHE PATENTSCHRIFT

(11) **EP 3 349 344 B1**
(45) Veröffentlichungstag und Bekanntmachung des Hinweises auf die Patenterteilung: **17.02.2021**
(21) Anmeldenummer: 17205076.7
(22) Anmeldetag: 04.12.2017
(51) Int. Cl.: H02M 7/00, H02M 1/44, H02B 1/20, H01R 13/24

(54) **FILTERANORDNUNG**
FILTER ASSEMBLY
SYSTÈME DE FILTRE

(30) Priorität: 10.01.2017 DE 102017100381
(43) Veröffentlichungstag der Anmeldung: 18.07.2018
(73) Patentinhaber: InTiCa Systems AG, 94032 Passau (DE)
(72) Erfinder: Würzinger, Mathias, 94160 Ringelai (DE)
(74) Vertreter: Wolf, Gerhard

(56) Entgegenhaltungen:
- EP-A1- 0 520 950
- EP-A1- 0 568 755
- CN-A- 103 247 984
- DE-C1- 19 507 790
- DE-U1-202013 104 784
- DE-U1-202016 104 468
- US-A- 4 013 329
- US-A1- 2005 277 336
- US-A1- 2011 261 508
- N/a N/a: "Compact High Power EMC/EMI DC Filter for e-Mobility", DATASHEET, 31 December 2016 (2016-12-31), XP055632056, Retrieved from the Internet: URL:https://datasheet.datasheetarchive.com /originals/crawler/schaffnerusa.com/f26d2a a4e8249ac1d32949161e3a0dd5.pdf [retrieved on 2019-10-15]

## Beschreibung

Die Erfindung betrifft eine Filteranordnung sowie ein Verfahren zur Herstellung einer Filteranordnung.

Elektrische bzw. elektronische Filter zur Entstörung von elektrischen Systemen und Anlagen sind grundsätzlich bekannt. Insbesondere sind Filter bekannt, die in einem Gleichspannungsnetz hochfrequente Signale, die in Gleichstrompfade eingekoppelt werden, ausfiltern, um die bestehenden Anforderungen hinsichtlich elektromagnetischer Verträglichkeit (EMV) des elektrischen Systems bzw. der Anlage zu erfüllen (sog. EMV-Filter).

Insbesondere bei elektrisch angetriebenen Fahrzeugen besteht das Problem, dass auf Stromschienen zwischen dem Energiespeicher (z.B. Batterieeinheit) und dem Elektromotor hohe elektrische Ströme übertragen werden müssen (z.B. Ströme bis zu 500A). Daher müssen die Stromschienen einen erheblichen Querschnitt (z.B. im cm²-Bereich) aufweisen, um eine übermäßige Erwärmung der Stromschienen zu vermeiden. An diese Stromschienen müssen elektrische Bauteile, insbesondere Kondensatoren angeschlossen werden, um die Ausfilterung der hochfrequenten Störanteile zu ermöglichen. Die sich beim Anschließen der Kondensatoren bildenden Übergangsimpedanzen (ohmsche Widerstände, parasitäre Induktivitäten etc.) müssen zudem möglichst klein sein.

Bislang erfolgt das Anschließen der elektrischen Filterbauelemente (insb. Kondensatoren) durch ein Anschweißen der Anschlussbereiche der Kondensatoren an die Stromschienen, insbesondere an Stromschienenbereiche, die vorher durch geeignete Materialbearbeitung (z.B. Bohren bzw. Fräsen) für ein Anschweißen vorbereitet wurden, um ein Verschweißen der dünn ausgebildeten Anschlussbereiche mit der Stromschiene erst zu ermöglichen. Dies ist zum einen zeit- und kostenintensiv, zum anderen aber fehleranfällig, da die Güte des elektrischen Kontakts maßgeblich von der Güte der Schweißverbindung abhängt, die erheblichen Schwankungen unterliegt.

Die Druckschrift DE 195 07 790 C1 offenbart eine Anordnung, bei der eine Trägerplatte mit leitenden Oberflächen zwischen einem Paar von Stromschienen befestigt ist.

Die Druckschrift DE 20 2016 104 468 U1 offenbart einen Filter mit Leiterplatte und Stromschienen.

Die Druckschrift EP 0 568 755 A1 offenbart eine Kontaktvorrichtung.

Ausgehend hiervon ist es Aufgabe der Erfindung, eine Filteranordnung anzugeben, die zeit- und kosteneffizient herstellbar ist und darüber hinaus eine zuverlässige elektrische Kontaktierung der Filterbauelemente ermöglicht.

Die Aufgabe wird durch die Merkmale des unabhängigen Patentanspruchs 1 gelöst. Bevorzugte Ausführungsformen sind Gegenstand der Unteransprüche. Ein Verfahren zur Herstellung einer Filteranordnung ist Gegenstand des nebengeordneten Patentanspruchs 14.

Gemäß einem ersten Aspekt bezieht sich die Erfindung auf eine Filteranordnung umfassend zumindest eine erste Stromschiene und eine zweite Stromschiene sowie ein Trägerelement, an dem zumindest ein Filterbauelement, insbesondere ein elektrischer Kondensator, angeordnet ist, das mit zumindest einer der Stromschienen elektrisch verbunden ist.

Die elektrische Verbindung des zumindest einen elektrischen Filterbauelements mit zumindest einer dieser Stromschienen erfolgt durch mechanisches Einspannen des Trägerelements zwischen der ersten und zweiten Stromschiene.

Die erfindungsgemäße Filteranordnung bietet den entscheidenden Vorteil, dass die elektrische Verbindung zwischen Stromschiene und Filterbauelement einfach und kostengünstig durch die mechanische Montage hergestellt werden kann. Damit kann insbesondere eine Verschweißung der Anschlussbereiche der Filterbauelemente mit den Stromschienen entfallen. Dies führt zum einen zu einer Reduzierung von Kontaktierungsfehlern, zum anderen zu Kostenvorteilen bei der Herstellung der Filteranordnung.

In einem bevorzugten Ausführungsbeispiel verlaufen die Stromschienen parallel zueinander und sind übereinander angeordnet. Damit kann erfindungsgemäß ein zwischen den Stromschienen angeordnetes Trägerelement durch Verspannen der Stromschienen gegeneinander fixiert werden und die elektrische Kontaktierung zwischen Stromschiene und Filterbauelement erfolgt durch Andrücken von Kontaktabschnitten während dieses mechanischen Verspannens.

In einem bevorzugten Ausführungsbeispiel ist das Trägerelement streifenförmig ausgebildet. Es kann insbesondere eine Breite (in Richtung der Längsachse der Stromschienen gemessen) aufweisen, die kleiner ist als die Länge (quer zur der Längsachse der Stromschienen gemessen) des Trägerelements. Das streifenförmige Trägerelement kann zwischen den Stromschienen angeordnet werden, um zwischen diesen mechanisch verspannt zu werden.

In einem bevorzugten Ausführungsbeispiel verläuft eine Längsachse des Trägerelements quer, insbesondere senkrecht zur Längsachse der Stromschienen. In dem Bereich, in dem die Stromschienen und das Trägerelement sich kreuzen, kann die elektrische Kontaktierung der Stromschienen zum Zweck der elektrischen Kopplung mit dem zumindest einen Filterbauelement erfolgen.

In einem bevorzugten Ausführungsbeispiel steht das Trägerelement an beiden Seiten der Stromschienen seitlich ab und an den abstehenden Bereichen ist jeweils ein Filterbauelement, insbesondere ein elektrischer Kondensator vorgesehen. Die abstehenden Bereiche dienen damit als Anschlussbereiche für die Filterbauelemente. Dadurch können die elektrischen Leitungen zwischen Stromschiene und Filterbauelement kurz gehalten werden.

In einem bevorzugten Ausführungsbeispiel koppelt ein erstes Filterbauelement, insbesondere ein elektrischer Kondensator die erste Stromschiene mit einem auf einem elektrischen Bezugspotential liegenden Bauteil. Das elektrische Bezugspotential kann insbesondere Erdpotential haben. Damit können auf der ersten Stromschiene vorhandene hochfrequente Störungen über das Filterbauelement abgeleitet und damit ausgefiltert werden.

In einem bevorzugten Ausführungsbeispiel koppelt ein zweites Filterbauelement, insbesondere ein elektrischer Kondensator die zweite Stromschiene mit einem auf einem elektrischen Bezugspotential liegenden Bauteil. Das elektrische Bezugspotential kann insbesondere Erdpotential haben. Damit können auf der zweiten Stromschiene vorhandene hochfrequente Störungen über das Filterbauelement abgeleitet und damit ausgefiltert werden.

Vorzugsweise sind die erste und zweite Stromschiene mit identisch dimensionierten Filterbauelementen gekoppelt. Diese sind vorzugsweise symmetrisch zueinander angeordnet, insbesondere spiegelsymmetrisch zur Längsachse der Stromschienen. Dadurch kann eine Entstörung beider Stromschienen gegen Gleichtaktsignale (common-mode-Filterung) erfolgen.

In einem bevorzugten Ausführungsbeispiel erfolgt die elektrische Verbindung zwischen der Stromschiene und einem auf dem Trägerelement befindlichen leitenden Bereich über einen zumindest einen federartig ausgebildeten Kontaktbereich aufweisenden Kontaktabschnitt (Kontaktfeder). Dieser federartig ausgebildete Kontaktbereich kann beim Einspannen des Trägerelements zwischen den Stromschienen zumindest teilweise elastisch verformt bzw. komprimiert werden. Dadurch kann eine verbesserte elektrische Kontaktierung der Stromschienen erzielt werden.

In einem bevorzugten Ausführungsbeispiel weist der Kontaktabschnitt mehrere Kontaktzungen auf. Die Kontaktzungen können zumindest abschnittsweise nach oben oder aber nach oben und unten in Bezug auf eine Mittelebene des Kontaktabschnitts abstehen. Das gleichzeitige nach oben und unten Abstehen der Kontaktzungen wird beispielsweise dadurch erreicht, dass diese vorzugsweise entlang deren Längsachse zumindest abschnittsweise verdreht sind, so dass Kantenbereiche nach oben und unten hin gegenüber der Mittelebene des Kontaktabschnitts abstehen. Die Verdrehung der Kontaktzungen kann beispielsweise vor dem Verklemmen zwischen dem Trägerelement und der Stromschiene zwischen 30° und 60°, beispielsweise zwischen 40° und 50°, insbesondere etwa 45° betragen. Dieser Verdrehwinkel kann dann durch das Verklemmen zwischen dem Trägerelement und der Stromschiene zumindest teilweise reduziert werden. Alternativ kann der Kontaktabschnitt auch andersartige elastisch verformbare Kontaktbereiche aufweisen, beispielsweise in Form eines spiralfederförmigen Kontaktbereichs.

In einem bevorzugten Ausführungsbeispiel ist zwischen dem Trägerelement und der Stromschiene im Bereich des Kontaktabschnitts zumindest ein Abstandshalter vorgesehen, der die Verformung des federartig ausgebildeten Kontaktbereichs begrenzt. Dadurch wird erreicht, dass der federartig ausgebildete Kontaktbereich unabhängig von der Kraft, mit der die Stromschienen gegeneinander verspannt werden, nur zu einem gewissen Grad verformt und nicht vollständig gegen das Trägerelement gepresst werden kann.

In einem bevorzugten Ausführungsbeispiel ist an dem Trägerelement an zwei einander gegenüberliegenden Trägerelementseiten jeweils ein Kontaktabschnitt vorgesehen. Dadurch kann mittels des Einspannens des Trägerelements eine gleichzeitige elektrische Kontaktierung der jeweiligen Stromschienen erfolgen, beispielsweise eine erste Stromschiene mittels eines unterseitigen Kontaktabschnitts und eine zweite Stromschiene mittels eines oberseitigen Kontaktabschnitts.

In einem bevorzugten Ausführungsbeispiel ist das Trägerelement eine Leiterplatte umfassend einen elektrisch isolierenden Leiterplattenträger und mehrere elektrisch leitfähige Leiterbahnbereiche. Über die Leiterbahnbereiche erfolgt die elektrische Kontaktierung zwischen Stromschiene und Kondensator bzw. zwischen Kondensator und einem auf einem Bezugspotential (insb. Erdpotential) befindlichen Bauteil. Die Leiterbahnbereiche können sich dabei über die gesamte Breite oder im Wesentlichen die gesamte Breite der Leiterplatte (insb. >80%) erstrecken. Dadurch wird eine optimierte Ableitung der Störanteile erreicht.

In einem bevorzugten Ausführungsbeispiel weist das Trägerelement einen Träger aus einem elektrisch nichtleitenden Material und daran angeordnete Stanzblechteile auf. Die Stanzblechteile dienen dabei der jeweiligen elektrischen Kontaktierung des Filterbauelements zur Stromschiene und zum auf Bezugspotential liegenden Bauteil hin. Dadurch können die Herstellungskosten der Filteranordnung weiter reduziert werden.

In einem bevorzugten Ausführungsbeispiel ist an einem die Stromschiene mit dem Filterbauelement verbindenden Stanzblechteil einstückig der federartig ausgebildete Kontaktbereich vorgesehen. In anderen Worten bildet der federartig ausgebildete Kontaktbereich einen integralen Bestandteil eines zur Kontaktierung zwischen Stromschiene und Filterbauelement befindlichen Stanzblechteils. Dadurch kann ein Verlöten eines Kontaktelements mit dem Stanzblechteil vermieden werden, was zu geringen Übergangswiderständen und damit zu verbesserten Filtereigenschaften führt.

In einem bevorzugten Ausführungsbeispiel weist die Filteranordnung mehrere entlang der Stromschienen zueinander beabstandete Trägerelemente auf, die jeweils zumindest ein Filterbauelement aufweisen. Zwischen diesen Trägerelementen kann eine Drossel vorgesehen sein, die durch einen ringförmigen Magnetkern bzw. durch einen gewickelten Bandkern, insbesondere nanokristallinen Bandkern gebildet ist. Die Drossel kann insbesondere einen Innenöffnung aufweisen, die an den Querschnitt der zueinander verklemmt angeordneten Stromschienen derart angepasst ist, dass die Drossel auf die Stromschienen aufschiebbar ist. Durch die induktive Wirkung des Magnetkerns an der Stromschiene wird die Wirkung einer Drossel erreicht.

Gemäß einem weiteren Aspekt betrifft die Erfindung ein Verfahren zur Herstellung einer Filteranordnung umfassend zumindest eine erste Stromschiene und eine zweite Stromschiene sowie ein Trägerelement, an dem zumindest ein elektrisches Filterbauelement angeordnet ist, das mit zumindest einer der Stromschienen elektrisch verbunden ist. Das zumindest eine elektrische Filterbauelement wird mit zumindest einer dieser Stromschienen durch mechanisches Einspannen des Trägerelements zwischen der ersten und zweiten Stromschiene elektrisch verbunden.

Unter "Filterbauelement" im Sinne der vorliegenden Erfindung wird jegliches elektrisches Bauelement verstanden, das zur Entstörung von Stromschienen verwendet werden kann. Filterbauelemente können insbesondere Kondensatoren, aber auch Induktivitäten oder elektrische Widerstände sein.

Die Ausdrücke "näherungsweise", "im Wesentlichen" oder "etwa" bedeuten im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren. Dabei sind alle beschriebenen und/oder bildlich dargestellten Merkmale für sich oder in beliebiger Kombination grundsätzlich Gegenstand der Erfindung, unabhängig von ihrer Zusammenfassung in den Ansprüchen oder deren Rückbeziehung. Auch wird der Inhalt der Ansprüche zu einem Bestandteil der Beschreibung gemacht.

Die Erfindung wird im Folgenden anhand der Figuren an Ausführungsbeispielen näher erläutert. Es zeigen:
- Fig. 1: beispielhaft eine erste Ausführungsform einer Filteranordnung in einer perspektivischen Ansicht;
- Fig. 2: beispielhaft eine Schnittdarstellung der Filteranordnung entlang der in Fig. 1 gezeigten Schnittlinie X-X;
- Fig. 3: beispielhaft der in Fig. 2 mit dem strichlierten Kreis gekennzeichnete Klemmbereich zwischen Stromschienenpaar und Trägerelement in einer Detaildarstellung;
- Fig. 4: beispielhaft eine oberseitige Darstellung des Trägerelements mit daran vorgesehenen Kondensatoren;
- Fig. 5: beispielhaft eine unterseitige Darstellung des Trägerelements mit daran vorgesehenen Kondensatoren;
- Fig. 6: beispielhaft eine zweite Ausführungsform einer Filteranordnung in einer perspektivischen Ansicht;
- Fig. 7: beispielhaft eine Schnittdarstellung der Filteranordnung entlang der in Fig. 6 gezeigten Schnittlinie X-X;
- Fig. 8: beispielhaft der in Fig. 7 mit dem strichlierten Kreis gekennzeichnete Klemmbereich zwischen Stromschienenpaar und Trägerelement in einer Detaildarstellung;
- Fig. 9: beispielhaft eine oberseitige Darstellung des Trägerelements gemäß dem zweiten Ausführungsbeispiel mit daran vorgesehenen Kondensatoren;
- Fig. 10: beispielhaft eine unterseitige Darstellung des Trägerelements gemäß dem zweiten Ausführungsbeispiel mit daran vorgesehenen Kondensatoren; und
- Fig. 11: beispielhaft ein schematisches Blockschaltbild einer beispielhaften Filteranordnung zum Ausfiltern von Störanteilen.

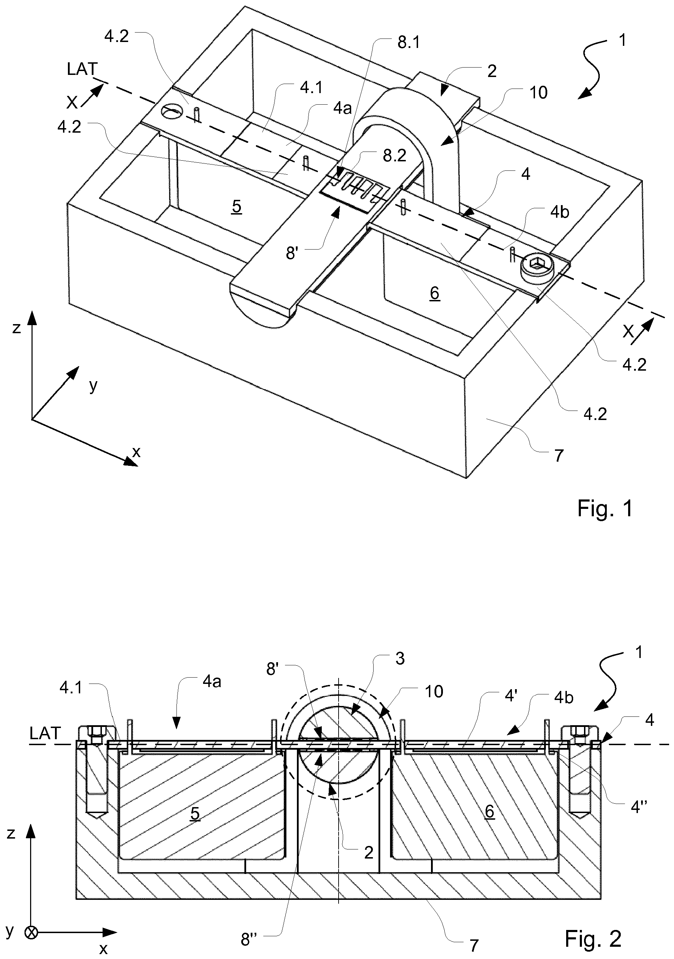

Die Figuren 1 bis 5 zeigen ein erstes Ausführungsbeispiel einer Filteranordnung 1 in unterschiedlichen Ansichten. Die nachfolgende Beschreibung der Filteranordnung 1 erfolgt unter Bezugnahme auf ein kartesisches Koordinatensystem mit senkrecht zueinander stehenden Achsen, nämlich einer x-Achse, eine y-Achse und einer z-Achse. Die Filteranordnung 1 umfasst ein Stromschienenpaar mit einer ersten Stromschiene 2 und einer zweiten Stromschiene 3. In der Darstellung gemäß Figur 1 ist lediglich die erste Stromschiene 2 gezeigt. Es versteht sich, dass auch mehr als zwei Stromschienen zur Bildung der Filteranordnung 1 vorgesehen sein können.

Die Stromschienen 2, 3 der Filteranordnung 1 bilden beispielsweise eine einen positiven und einen negativen elektrischen Leiter, der eine Energiespeichereinheit, beispielsweise eine elektrische Batterie, mit einem elektrischen Verbraucher, beispielsweise einem Elektromotor verbindet. Die Stromschienen 2, 3 sind im gezeigten Ausführungsbeispiel in z-Richtung übereinander angeordnet und verlaufen mit ihren Längsachsen LAS parallel zueinander in y-Richtung. Vorzugsweise sind die Stromschienen 2, 3 im Querschnitt halbrund ausgebildet und mit ihren Flachseiten einander zugewandt beabstandet angeordnet, so dass die übereinander angeordneten Stromschienen 2, 3 ein im Querschnitt kreisrundes Stromschienenpaar bilden. Die Beabstandung der Stromschienen 2, 3 kann abschnittsweise durch geeignete Isoliermaterialien erfolgen.

Zur Entstörung der Stromschienen 2, 3 weist die Filteranordnung 1 ein Trägerelement 4 auf, an dem zumindest ein, im gezeigten Ausführungsbeispiel zwei Kondensatoren 5, 6 vorgesehen sind. Das Trägerelement 4 ist im gezeigten Ausführungsbeispiel streifenartig ausgebildet, wobei die Breite des Trägerelements 4 kleiner ist als die Länge des Trägerelements 4 entlang dessen Längsachse LAT. Dieses Trägerelement 4 ist zwischen den beiden Stromschienen 2, 3 derart angeordnet, dass die Längsachse LAT des Trägerelements 4 quer, insbesondere rechtwinklig zur Längsachse LAS der Stromschienen 2, 3 verläuft (im gezeigten Ausführungsbeispiel in x-Richtung). Die Fixierung des Trägerelements 4 zwischen den Stromschienen 2, 3 erfolgt durch mechanisches Verklemmen des Trägerelements 4. Dabei liegt eine flach ausgebildete Oberseite der ersten, unteren Stromschiene 2 gegenüber der Unterseite des Trägerelements 4 und eine flach ausgebildete Unterseite der zweiten, oberen Stromschiene 3 gegenüber der Oberseite des Trägerelements 4 an.

Das Trägerelements 4 ist derart gegenüber der ersten und zweiten Stromschiene 2, 3 angeordnet, dass zwei gleichlange oder im Wesentlichen gleichlange Trägerelementbereiche 4a, 4b von dem Stromschienenpaar zu unterschiedlichen Seiten hin abstehen. Beispielsweise steht der erste Trägerelementbereich 4a zur linken Seite hin, der zweite Trägerelementbereich 4b zur rechten Seite hin ab. An dem ersten Trägerelementbereich 4a ist dabei der erste Kondensator 5, an dem zweiten Trägerelementbereich 4b der zweite Kondensator 6 vorgesehen. Dadurch wird eine in Bezug auf die Längsachse LAS der Stromschienen 2, 3 spiegelsymmetrische oder im Wesentlichen spiegelsymmetrische Filteranordnung 1 erreicht. Wie im Ausführungsbeispiel gemäß Figur 1 gezeigt, können die Kondensatoren 5, 6 hängend, d.h. nach unten hin in Richtung der ersten Stromschiene 2 abstehend, an dem Trägerelement 4 angeordnet sein.

Um die Stromschienen 2, 3 elektrisch mit den Kondensatoren 5, 6 zum Zweck der Entstörung der Stromschienen 2, 3 zu koppeln, sind jeweils an der Oberseite 4' und der Unterseite 4" des Trägerelements 4 elektrisch leitfähige Bereiche vorgesehen. Im in den Figuren 1 bis 5 gezeigten Ausführungsbeispiel ist das Trägerelement 4 durch eine Leiterplatte 4.1 gebildet, an der oberseitig und unterseitig mehrere Leiterbahnbereiche 4.2 vorgesehen sind.

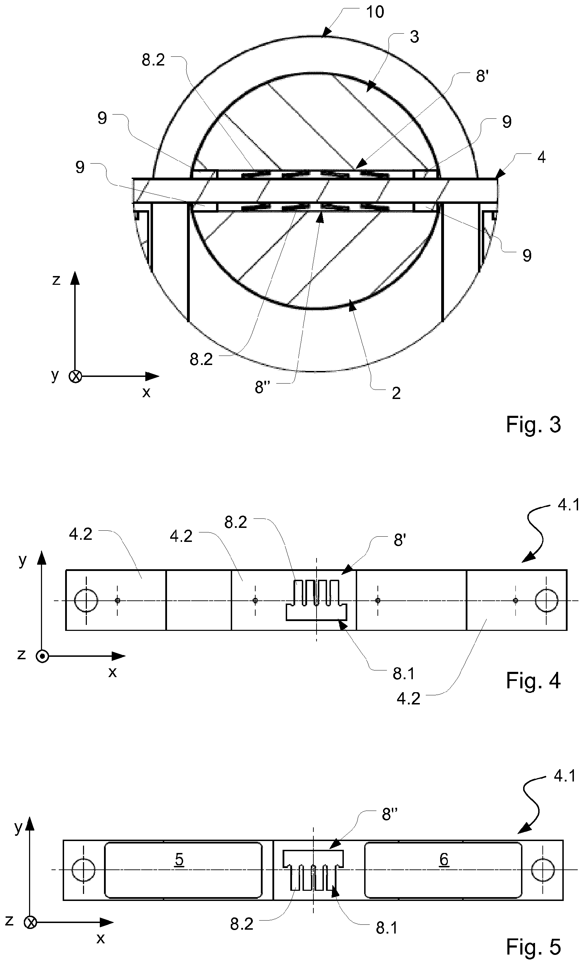

Wie insbesondere in Fig. 3 bis 5 ersichtlich, kann jeweils an der Oberseite 4' und der Unterseite 4" ein Kontaktabschnitt 8', 8" vorgesehen sein. Dieser Kontaktabschnitt 8', 8" ist jeweils über Leiterbahnbereiche 4.2 mit dem Kondensator 5, 6 elektrisch gekoppelt. Dadurch kann eine elektrische Verbindung zwischen den Stromschienen 2, 3 und den Kondensatoren 5, 6 gebildet werden. So ist beispielsweise an der Oberseite 4' des Trägerelements 4 ein Kontaktabschnitt 8' vorgesehen, mittels dem die zweite Stromschiene 3 mit dem ersten Kondensator 5 elektrisch verbunden ist und an der Unterseite 4" des Trägerelements 4 ist ein Kontaktabschnitt 8" vorgesehen, mittels dem die erste Stromschiene 2 mit dem zweiten Kondensator 6 elektrisch verbunden ist. Es versteht sich, dass auch die umgekehrte Verbindungsmöglichkeit besteht.

Die Kontaktabschnitte 8', 8" weisen einen federartig ausgebildeten Kontaktbereich 8.1 auf. Im gezeigten Ausführungsbeispiel ist der Kontaktbereich 8.1 kammartig mit mehreren nach oben hin oder aber nach oben und unten hin abstehenden Kontaktzungen 8.2 ausgebildet. Diese Kontaktzungen 8.2 werden beim Einspannen des Trägerelements 4 zwischen den beiden Stromschienen 2, 3 elastisch verformt bzw. in Richtung einer horizontalen Ausrichtung deformiert, so dass die Kontaktzungen 8.2 durch die Rückstellkräfte an die Stromschienen 2, 3 angedrückt werden. Dadurch ergibt sich ein niederohmiger Übergangswiderstand zwischen den Leiterbahnbereichen 4.2 und den Kontaktabschnitten 8', 8" und damit ein niederohmiger Anschluss der Kondensatoren 5, 6 an die Stromschienen 2, 3, und zwar ohne Verwendung einer Löt- oder Schweißverbindung. Alternativ zu den Kontaktzungen sind auch andere federartig ausgebildete Kontaktbereichsvarianten möglich, beispielsweise ein Kontaktbereich 8.1 mit spiralfederartigen Kontaktelementen.

Im Falle der Verwendung einer Leiterplatte 8.1 kann der Kontaktabschnitt 8', 8" beispielsweise durch ein auf einen Leiterbahnbereich 4.2 aufgelötetes Kontaktfederelement gebildet werden. Alternativ ist es möglich, dass das Kontaktfederelement lediglich lose auf den Leiterbahnbereich 4.2 aufgelegt oder mit diesem verklebt wird. Die elektrische Kontaktierung zwischen dem Leiterbahnbereich 4.2 und der jeweiligen Stromschiene 2, 3 erfolgt dann über den Kontaktabschnitt 8', 8"derart, dass ein federartig ausgebildeter Kontaktbereich 8.1 verwendet wird, der sowohl eine elektrische Kontaktierung zum Leiterbahnbereich 4.2 als auch zur Stromschiene 2, 3 hin bewirkt, beispielsweise durch nach oben und unten hin abstehende Kontaktzungen 8.2. Das Abstehen nach oben und unten hin kann insbesondere durch eine Verdrehung um 45° oder im Wesentlichen 45° um die Längsachse der Kontaktzungen 8.2 erreicht werden.

Zur Ableitung der Störanteile sind die Kondensatoren 5, 6, wie insbesondere in Fig. 2 zu erkennen, mit einem den Stromschienen 2, 3 abgewandten Anschlussbereich mit einem Bauteil 7 elektrisch gekoppelt, das beispielsweise durch ein Gehäuse aus einem elektrisch leitfähigen Material gebildet ist. Dieses Bauteil 7 liegt beispielsweise auf einem Bezugspotential, insbesondere auf Erdpotential. Die elektrische Verbindung mit dem Bauteil 7 kann durch eine Verschraubung o.ä. und einen Leiterbahnbereich 4.2 erfolgen, der den Anschlussbereich des Kondensators 5, 6 mit dem Bauteil 7 elektrisch verbindet. Die Verschraubung kann beispielsweise auch die Fixierung des freien Endes des Trägerelements 4 bewirken. Wie in Fig. 1 und 2 gezeigt, können ein oder mehrere Bügel 10 verwendet werden, um die Stromschienen 2, 3 zu fixieren.

Wie insbesondere in Fig. 3 zu erkennen ist, können die Kontaktzungen 8.2 zumindest abschnittsweise gegenüber der x-y-Ebene verdreht sein, und zwar insbesondere um eine parallel zur y-Achse verlaufende Drehachse. Dadurch stehen Kantenbereiche der Kontaktzungen 8.2 gegenüber den übrigen Bereichen der Kontaktzungen 8.2 nach oben ab, wodurch sich beim Verklemmen der Stromschienen 2, 3 gegeneinander eine Anlage der Stromschienen 2, 3 gegenüber diesen Kantenbereichen ergibt. Dadurch wird der elektrische Kontakt zwischen den Kontaktabschnitten 8, 8' und den Stromschienen 2, 3 weiterhin verbessert.

Im Bereich des Kontaktabschnitts 8', 8" kann ein Abstandshalter 9 vorgesehen sein. Dieser Abstandshalter 9 kann beispielsweise rahmenartig um den jeweiligen Kontaktabschnitt 8', 8" herum verlaufen oder aber auch lediglich punktweise oder abschnittsweise um den Kontaktabschnitt 8', 8" herum vorgesehen sein. Die Höhe des Abstandshalters 9 kann derart gewählt sein, dass die Verformung der Kontaktzungen 8.2 begrenzt wird, d.h. die Kontaktzungen 8.2 werden durch die Verklemmung der Stromschienen 2, 3 nicht vollständig gegen das Trägerelement 4 gedrückt, sondern bleiben zu diesem zumindest abschnittsweise beabstandet (s. Fig. 3).

Für den Fall dass das Bauteil 7 durch ein schalenartig ausgebildetes Gehäuse gebildet ist, kann dieses Gehäuse mit einem geeigneten Vergussmaterial, beispielsweise einem Epoxidharz o.ä. vergossen werden. Dadurch können die Kondensatoren 5, 6 und ggf. die Trägerelementbereiche 4a, 4b gegen Feuchtigkeit und Erschütterungen geschützt werden.

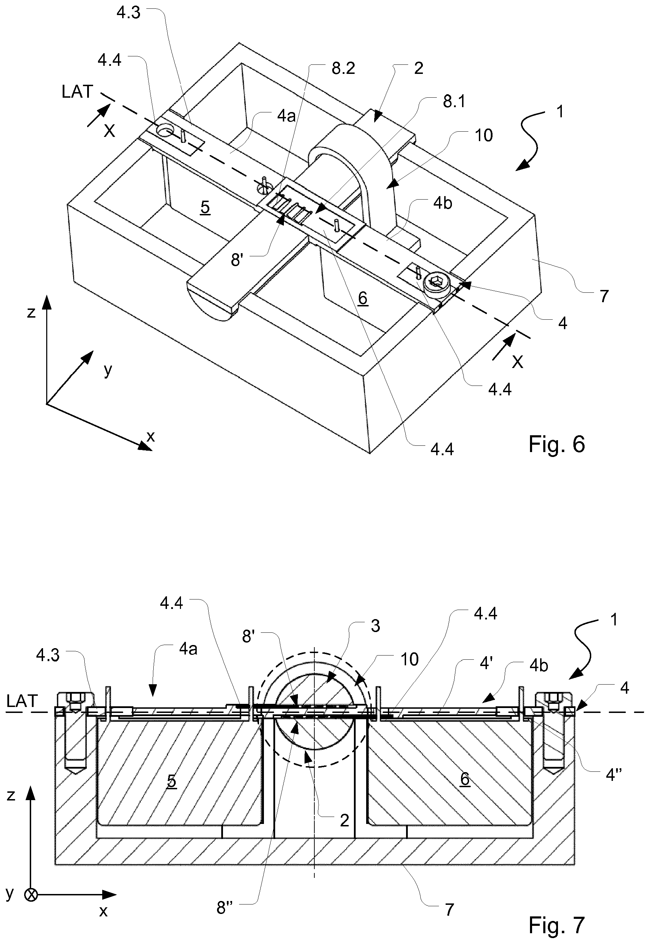

Fig. 6 bis 10 zeigen ein weiteres Ausführungsbeispiel einer erfindungsgemäßen Filteranordnung 1. Dabei entspricht die Darstellung gemäß Fig. 6 der Darstellung in Fig. 1, die Darstellung gemäß Fig. 7 der Darstellung in Fig. 2 usw. Nachfolgend werden lediglich die Unterschiede des zweiten Ausführungsbeispiels gegenüber dem ersten Ausführungsbeispiel erläutert. Im Übrigen gelten die vorherigen Ausführungen auch für das zweite Ausführungsbeispiel.

Der wesentliche Unterschied zwischen dem ersten und zweiten Ausführungsbeispiel besteht in der Ausbildung des Trägerelements 4. Im zweiten Ausführungsbeispiel ist das Trägerelement 4 durch einen Träger 4.3 aus einem elektrisch nichtleitenden Material gebildet, auf dem mehrere Stanzblechteile 4.4 (auch als Stanzgitter bezeichnet) angeordnet sind. Die Unter "Stanzblechteile" werden hierbei jegliche Blechteile verstanden, die durch Stanzen oder aber auch durch andere Materialbearbeitung, beispielsweise Laserschneiden hergestellt sind. Diese Stanzblechteile 4.4 sind durch geeignete Verbindungstechniken auf dem Träger 4.3 angeordnet. So können die Stanzblechteile 4.4 beispielsweise in am Träger vorgesehene Ausnehmungen eingeschoben bzw. eingesetzt sein. Auch eine Fixierung durch Umspritzen, Vergießen oder Verkleben ist denkbar.

Wie in Fig. 6 und 7 ersichtlich, können die Anschlussbereiche der Kondensatoren 5, 6 mit den Stanzblechteilen 4.4 beispielsweise durch Verlöten elektrisch verbunden sein, um eine Kontaktierung der Kondensatoren 5, 6 zu den Stromschienen 2, 3 einerseits und zu dem Bauteil 7 hin andererseits zu gewährleisten.

Die Kontaktabschnitte 8', 8" können vorteilhafterweise an den Stanzblechteilen ausgebildet sein, und zwar insbesondere einstückig. Beispielsweise kann durch Stanzen oder Schneiden ein Kontaktbereich 8.1 mit Kontaktzungen 8.2 erzeugt werden. So weisen insbesondere die Stanzblechteile 4.4, die die neben den Stromschienen 2, 3 liegenden Kontaktbereiche mit diesen Stromschienen 2, 3 elektrisch verbinden, einen Kontaktbereich 8.1 mit Kontaktzungen 8.2 auf. Durch die einstückige Ausbildung der Kontaktabschnitte 8', 8" wird erreicht, dass keine Lötstellen zwischen den Kontaktabschnitten 8', 8" nötig sind und damit keine durch die Lötstellen verursachten Übergangswiderstände entstehen.

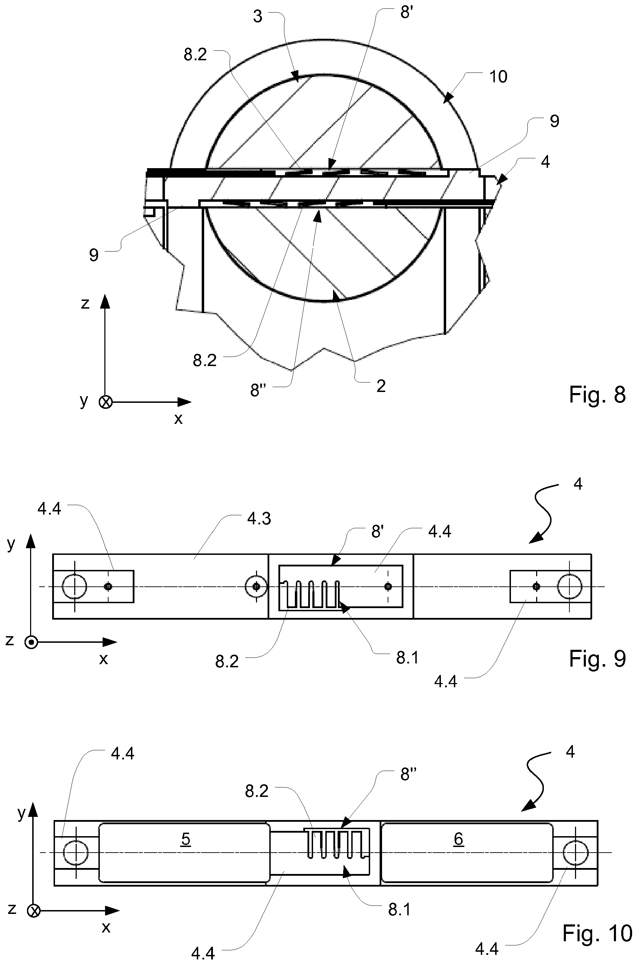

Wie im Zusammenhang mit dem ersten Ausführungsbeispiel bereits ausgeführt, können im Bereich der Kontaktabschnitte 8', 8" Abstandshalter 9 vorgesehen sein. Wie insbesondere in Fig. 7 und 8 zu erkennen, können diese insbesondere einstückig am Träger 4.3 ausgebildet sein. Alternativ können die Abstandshalter 9 auch durch geeignete Verbindungsverfahren, beispielsweise Kleben am Träger 4.3 angeordnet sein.

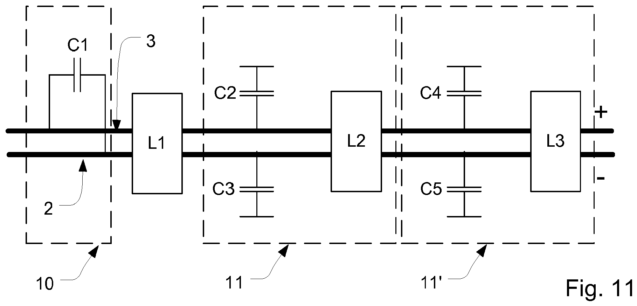

Fig. 11 zeigt exemplarisch ein schematisches Blockschaltbild einer Filteranordnung 1, die gemäß den zuvor beschriebenen Ausführungsbeispielen gebildet sein kann. Der in Fig. 11 gezeigte positive (+) und negative (-) Leiter wird durch die Stromschienen 2, 3 gebildet. An diese Stromschienen 2, 3 sind mehrere Kondensatoren C1 bis C5 angeschlossen, um eine Entstörung der Stromschienen 2, 3 zu bewirken. Der Kondensator C1 ist mit einem ersten Anschlussbereich (Pin) mit der ersten Stromschiene 2 und mit dem zweiten Anschlussbereich mit der zweiten Stromschiene 3 elektrisch verbunden. Der Kondensator C1 (X-Kondensator) bildet einen sog. differential-mode-Filter 10, mittels dem hochfrequente Spannungsdifferenzen zwischen den Stromschienen 2, 3 (Gegentaktstörspannungen) ausgeglichen werden.

Die Kondensatoren C2, C3 bilden zusammen mit der Spule L2, die Kondensatoren C4, C5 zusammen mit der Spule L3 sog. common- mode Filter 11, 11', mittels denen Gleichtaktstörungen, die in gleicher Phase an den Stromschienen 2, 3 auftreten, ausgefiltert werden. Die Kondensatoren C2 bis C5 sind hierzu mit einem Anschlussbereich mit dem Bezugspotential, insbesondere Erde verbunden.

Die elektrische Kontaktierung der Kondensatoren 5, 6 erfolgt, wie zuvor beschrieben, durch ein mechanisches Einspannen eines Trägerelements 4 zwischen den Stromschienen 2, 3.

Die Spulen L1, L2, L3 können insbesondere auf das aus den Stromschienen 2, 3 gebildete Stromschienenpaar aufgesteckt sein. Die Spulen L1, L2, L3 können insbesondere ringartig ausgebildete Magnetkerne aus einem nanokristallinen Bandmaterial gebildet sein. Dadurch kann die Wirkung der Spulen L1, L2, L3 entscheidend gesteigert werden.

Die Magnetkerne und die die Filterbauelemente aufweisenden Trägerelemente 4 können dabei nacheinander, insbesondere abwechselnd nacheinander auf das Stromschienenpaar aufgesteckt werden, so dass eine einfache Montage der Filteranordnung 1 möglich ist. Die Magnetkerne können dabei einstückig, d.h. nicht teilbar ausgebildet sein.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrunde liegend Erfindungsgedanke verlassen wird.

Voranstehend wurde davon ausgegangen, dass der Kondensator 5, 6 direkt mit dem auf Bezugspotential befindlichen Bauteil 7 gekoppelt ist. Es versteht sich, dass - abhängig von den geforderten Filtereigenschaften - auch mehrere Filterbauelemente (Filterbauelementgruppe)bzw.

Filtereinheiten (mit einem komplexen Filteraufbau) zwischen der Stromschiene und dem auf Bezugspotential befindlichen Bauteil 7 vorgesehen sein können, um eine gewünschte Filterwirkung zu erzielen. Die elektrische Kontaktierung dieser Filterbauelementgruppe bzw. der Filtereinheit im Bereich der Stromschiene erfolgt jedoch über die vorbeschriebene mechanische Klemmung im Bereich der Stromschienen.

### Bezugszeichenliste

- 1: Filteranordnung
- 2: erste Stromschiene
- 3: zweite Stromschiene
- 4: Trägerelement
- 4': Oberseite
- 4": Unterseite
- 4a, 4b: Trägerelementbereich
- 4.1: Leiterplatte
- 4.2: Leiterbahnbereich
- 4.3: Träger
- 4.4: Stanzblechteil
- 5: erster Kondensator
- 6: zweiter Kondensator
- 7: Bauteil
- 8', 8": Kontaktabschnitt
- 8.1: Kontaktbereich
- 8.2: Kontaktzungen
- 9: Abstandshalter
- 10: differential-mode Filter
- 11: common-mode Filter

- LAS: Längsachse der Stromschiene
- LAT: Längsachse des Trägerelements

## Patentansprüche

1. Filteranordnung umfassend zumindest eine erste Stromschiene (2) und eine zweite Stromschiene (3) sowie ein Trägerelement (4), an dem zumindest ein elektrisches Filterbauelement (5, 6) angeordnet ist, das mit zumindest einer der Stromschienen (2, 3) elektrisch verbunden ist, wobei die elektrische Verbindung des zumindest einen elektrischen Filterbauelements (5, 6) mit zumindest einer dieser Stromschienen (2, 3) durch mechanisches Einspannen des Trägerelements (4) zwischen der ersten und zweiten Stromschiene (2, 3) erfolgt, wobei die elektrische Verbindung zwischen der Stromschiene (2, 3) und einem auf dem Trägerelement (4) befindlichen leitenden Bereich über einen zumindest einen federartig ausgebildeten Kontaktbereich (8.1) aufweisenden Kontaktabschnitt (8', 8") erfolgt, wobei das zwischen den Stromschienen (2, 3) angeordnete Trägerelement (4) durch Verspannen der Stromschienen (2, 3) gegeneinander fixiert wird und die elektrische Kontaktierung zwischen Stromschiene (2, 3) und Filterbauelement (5, 6) durch Andrücken von Kontaktabschnitten (8', 8") während dieses mechanischen Verspannens erfolgt, wobei ein erstes Filterbauelement (5) die erste Stromschiene (2) mit einem auf einem elektrischen Bezugspotential liegenden Bauteil (7) koppelt und wobei ein zweites Filterbauelement (6) die zweite Stromschiene (3) mit einem auf einem elektrischen Bezugspotential liegenden Bauteil (7) koppelt.

2. Filteranordnung nach Anspruch 1, **dadurch gekennzeichnet, dass** die Stromschienen (2, 3) parallel zueinander verlaufen und übereinander angeordnet sind.

3. Filteranordnung nach Anspruch 1 oder 2, **dadurch gekennzeichnet, dass** das Trägerelement (4) streifenförmig ausgebildet ist.

4. Filteranordnung nach einem der vorhergehenden Ansprüche, **dadurch gekennzeichnet, dass** eine Längsachse (LAT) des Trägerelements (4) quer zur Längsachse (LAS) der Stromschienen (2, 3) verläuft.

5. Filteranordnung nach einem der vorhergehenden Ansprüche, **dadurch gekennzeichnet, dass** das Trägerelement (4) an beiden Seiten der Stromschienen (2, 3) seitlich absteht und an den abstehenden Bereichen (4a, 4b) jeweils ein Filterbauelement (5, 6) vorgesehen ist.

6. Filteranordnung nach einem der vorhergehenden Ansprüche, **dadurch gekennzeichnet, dass** der Kontaktabschnitt (8', 8") mehrere nach oben hin oder nach oben und unten hin abstehende Kontaktzungen (8.2) aufweist.

7. Filteranordnung nach einem der vorhergehenden Ansprüche, **dadurch gekennzeichnet, dass** zwischen dem Trägerelement (4) und der Stromschiene (2, 3) im Bereich des Kontaktabschnitts (8', 8") zumindest ein Abstandshalter (9) vorgesehen ist, der die Verformung des federartig ausgebildeten Kontaktbereichs (8.1) begrenzt.

8. Filteranordnung nach einem der vorhergehenden Ansprüche, **dadurch gekennzeichnet, dass** an dem Trägerelement (4) an zwei einander gegenüberliegenden Trägerelementseiten (4', 4") jeweils ein Kontaktabschnitt (8', 8") vorgesehen ist.

9. Filteranordnung nach einem der vorhergehenden Ansprüche, **dadurch gekennzeichnet, dass** das Trägerelement (4) eine Leiterplatte (4.1) mit mehreren Leiterbahnbereichen (4.2) ist.

10. Filteranordnung nach einem der vorhergehenden Ansprüche 1 bis 8, **dadurch gekennzeichnet, dass** das Trägerelement (4) einen Träger (4.3) aus einem elektrisch nichtleitenden Material und daran angeordnete Stanzblechteile (4.4) aufweist.

11. Filteranordnung nach Anspruch 10, **dadurch gekennzeichnet, dass** an einem die Stromschiene (2, 3) mit dem Filterbauelement (5, 6) verbindenden Stanzblechteil (4.4) einstückig der federartig ausgebildete Kontaktbereich (8.1) vorgesehen ist.

12. Verfahren zur Herstellung einer Filteranordnung (1) umfassend zumindest eine erste Stromschiene (2) und eine zweite Stromschiene (3) sowie ein Trägerelement (4), an dem zumindest ein elektrisches Filterbauelement (5, 6) angeordnet ist, das mit zumindest einer der Stromschienen (2, 3) elektrisch verbunden ist, wobei das zumindest eine elektrische Filterbauelement (5, 6) mit zumindest einer dieser Stromschienen (2, 3) durch mechanisches Einspannen des Trägerelements (4) zwischen der ersten und zweiten Stromschiene (2, 3) elektrisch verbunden wird, wobei die elektrische Verbindung zwischen der Stromschiene (2, 3) und einem auf dem Trägerelement (4) befindlichen leitenden Bereich über einen zumindest einen federartig ausgebildeten Kontaktbereich (8.1) aufweisenden Kontaktabschnitt (8', 8") erfolgt und wobei das zwischen den Stromschienen (2, 3) angeordnete Trägerelement (4) durch Verspannen der Stromschienen (2, 3) gegeneinander fixiert wird und die elektrische Kontaktierung zwischen Stromschiene (2, 3) und Filterbauelement (5, 6) durch Andrücken von Kontaktabschnitten (8', 8") während dieses mechanischen Verspannens erfolgt, wobei die erste Stromschiene (2) durch ein erstes Filterbauelement (5) mit einem auf einem elektrischen Bezugspotential liegenden Bauteil (7) gekoppelt wird und wobei die zweite Stromschiene (3) durch ein zweites Filterbauelement (6) mit einem auf einem elektrischen Bezugspotential liegenden Bauteil (7) gekoppelt wird.

## Claims

1. Filter assembly comprising at least a first busbar (2) and a second busbar (3) as well as a carrier element (4) on which at least one electrical filter component (5, 6) is arranged, which is electrically connected to at least one of the busbars (2, 3), the at least one electrical filter component (5, 6) being electrically connected to at least one of these busbars (2, 3) by mechanically clamping the carrier element (4) between the first and second busbars (2, 3), the electrical connection between the busbar (2, 3) and a conductive region located on the carrier element (4) being established via a contact portion (8', 8") having at least one spring-like contact region (8.1), wherein the carrier element (4) arranged between the busbars (2, 3) is secured by bracing the busbars (2, 3) against one another and the electrical contact between the busbars (2, 3) and the filter component (5, 6) is established by compressing contact portions (8', 8") while this mechanical bracing takes place, a first filter component (5) coupling the first busbar (2) to a component (7), which is at an electrical reference potential, and a second filter component (6) coupling the second busbar (3) to a component (7), which is at an electrical reference potential.

2. Filter assembly according to claim 1, **characterized in that** the busbars (2, 3) run parallel to one another and are arranged one above the other.

3. Filter assembly according to claim 1 or 2, **characterized in that** the carrier element (4) is designed in the form of a strip.

4. Filter assembly according to any of the preceding claims, **characterized in that** a longitudinal axis (LAT) of the carrier element (4) extends transversely to the longitudinal axis (LAS) of the busbars (2, 3).

5. Filter assembly according to any of the preceding claims, **characterized in that** the carrier element (4) protrudes laterally on both sides of the busbars (2, 3) and a filter component (5, 6) is provided on each of the protruding areas (4a, 4b).

6. Filter assembly according to any of the preceding claims, **characterized in that** the contact portion (8', 8") has a plurality of contact tongues (8.2) protruding upwards or upwards and downwards.

7. Filter assembly according to any of the preceding claims, **characterized in that** at least one spacer (9) is provided between the carrier element (4) and the busbar (2, 3) in the region of the contact portion (8', 8"), which spacer delimits the deformation of the spring-like contact region (8.1).

8. Filter assembly according to any of the preceding claims, **characterized in that** a contact portion (8', 8") is provided on the carrier element (4) on each of two opposite carrier element sides (4', 4").

9. Filter assembly according to any of the preceding claims, **characterized in that** the carrier element (4) is a printed circuit board (4.1) having a plurality of conductor track regions (4.2).

10. Filter assembly according to any of the preceding claims 1 to 8, **characterized in that** the carrier element (4) has a carrier (4.3) made of an electrically non-conductive material and punching sheet parts (4.4) arranged thereon.

11. Filter assembly according to claim 10, **characterized in that** the spring-like contact region (8.1) is provided integrally on a punching sheet part (4.4) connecting the busbar (2, 3) to the filter component (5, 6).

12. Method for producing a filter assembly(1) comprising at least a first busbar (2) and a second busbar (3) as well as a carrier element (4), on which at least one electrical filter component (5, 6) is arranged, which is electrically connected to at least one of the busbars (2, 3), the at least one electrical filter component (5, 6) being electrically connected to at least one of these busbars (2, 3) by mechanically clamping the carrier element (4) between the first and second busbars (2, 3), the electrical connection between the busbar (2, 3) and a conductive region located on the carrier element (4) being established via a contact portion (8', 8") having at least one spring-like contact region (8. 1) and the carrier element (4) arranged between the busbars (2, 3) being secured by bracing the busbars (2, 3) against one another and the electrical contact between busbar (2, 3) and filter component (5, 6) being established by compressing contact portions (8', 8") while this mechanical bracing takes place, wherein the first busbar (2) is coupled by a first filter component (5) to a component (7), which is at an electrical reference potential, and wherein the second busbar (3) is coupled by a second filter component (6) to a component (7), which is at an electrical reference potential.

## Revendications

1. Système de filtre comprenant au moins une première barre conductrice (2) et une seconde barre conductrice (3) ainsi qu'un élément porteur (4) sur lequel est disposé au moins un composant de filtre électrique (5, 6) qui est connecté électriquement à l'une au moins desdites barres conductrices (2, 3),
dans lequel
la connexion électrique dudit au moins un composant de filtre électrique (5, 6) avec l'une au moins desdites barres conductrices (2, 3) est réalisée par serrage mécanique de l'élément porteur (4) entre la première et la seconde barre conductrice (2, 3),
la connexion électrique entre la barre conductrice (2, 3) et une zone conductrice située sur l'élément porteur (4) est établie par l'intermédiaire d'au moins une portion de contact (8', 8") comprenant au moins une zone de contact (8.1) réalisée sous forme de ressort,
l'élément porteur (4) disposé entre les barres conductrices (2, 3) est fixé par serrage des barres conductrices (2, 3) l'une contre l'autre, et
la mise en contact électrique entre la barre conductrice (2, 3) et le composant de filtre (5, 6) est réalisée par application de portions de contact (8', 8") pendant ledit serrage mécanique,
un premier composant de filtre (5) couple la première barre conductrice (2) à un composant (7) se trouvant à un potentiel électrique de référence, et
un second composant de filtre (6) couple la seconde barre conductrice (3) à un composant (7) se trouvant à un potentiel électrique de référence.

2. Système de filtre selon la revendication 1,
**caractérisé en ce que**
les barres conductrices (2, 3) sont parallèles entre elles et sont disposées l'une au-dessus de l'autre.

3. Système de filtre selon la revendication 1 ou 2,
**caractérisé en ce que** l'élément porteur (4) est réalisé sous la forme d'une bande.

4. Système de filtre selon l'une des revendications précédentes,
**caractérisé en ce qu'**un axe longitudinal (LAT) de l'élément porteur (4) s'étend transversalement à l'axe longitudinal (LAS) des barres conductrices (2, 3).

5. Système de filtre selon l'une des revendications précédentes,
**caractérisé en ce que**
l'élément porteur (4) fait saillie latéralement des deux côtés des barres conductrices (2, 3), et
un composant de filtre (5, 6) est prévu sur chacune des zones en saillie (4a, 4b).

6. Système de filtre selon l'une des revendications précédentes,
**caractérisé en ce que**
la portion de contact (8, 8") comprend plusieurs languettes de contact (8.2) qui font saillie vers le haut ou vers le haut et vers le bas.

7. Système de filtre selon l'une des revendications précédentes,
**caractérisé en ce que**
au moins un élément écarteur (9) est prévu entre l'élément porteur (4) et la barre conductrice (2, 3) au niveau de la portion de contact (8', 8") et limite la déformation de la zone de contact (8.1) réalisée en forme de ressort.

8. Système de filtre selon l'une des revendications précédentes,
**caractérisé en ce que**
une portion de contact respective (8', 8") est prévue sur l'élément porteur (4) sur chacun des deux côtés opposés de l'élément porteur (4', 4").

9. Système de filtre selon l'une des revendications précédentes,
**caractérisé en ce que**
l'élément porteur (4) est une carte de circuit imprimé (4.1) avec plusieurs zones de pistes conductrices (4.2).

10. Système de filtre selon l'une des revendications précédentes 1 à 8,
**caractérisé en ce que**
l'élément porteur (4) comprend un support (4.3) en un matériau non conducteur de l'électricité et des pièces de tôle découpées (4.4) disposées sur celui-ci.

11. Système de filtrage selon la revendication 10,
**caractérisé en ce que**
la zone de contact (8.1) réalisée en forme de ressort est prévue d'un seul tenant sur une pièce de tôle découpée (4.4) reliant la barre conductrice (2, 3) au composant de filtre (5, 6).

12. Procédé de fabrication d'un système de filtre (1) comprenant au moins une première barre conductrice (2) et une seconde barre conductrice (3) ainsi qu'un élément porteur (4) sur lequel est disposé au moins un composant de filtre électrique (5, 6) qui est connecté électriquement à l'une au moins des barres conductrices (2, 3),
dans lequel
ledit au moins un composant de filtre électrique (5, 6) est connecté électriquement à l'une au moins desdites barres conductrices (2, 3) par serrage mécanique de l'élément porteur (4) entre la première et la seconde barre conductrice (2, 3),
la connexion électrique entre la barre conductrice (2, 3) et une zone conductrice située sur l'élément porteur (4) est établie par l'intermédiaire d'au moins une portion de contact (8', 8") comprenant au moins une zone de contact (8.1) réalisée en forme de ressort, et
l'élément porteur (4) disposé entre les barres conductrices (2, 3) est fixé par serrage des barres conductrices (2, 3) l'une contre l'autre, et
la mise en contact électrique entre la barre conductrice (2, 3) et le composant de filtre (5, 6) est réalisée par application de portions de contact (8', 8") pendant ledit serrage mécanique,
la première barre conductrice (2) est couplée à un composant (7), se trouvant à un potentiel électrique de référence, par l'intermédiaire d'un premier composant de filtre (5), et
la seconde barre conductrice (3) est couplée à un composant (7), se trouvant à un potentiel électrique de référence, par l'intermédiaire d'un second composant de filtre (6).
